# EUROPÄISCHE PATENTSCHRIFT

(11) **EP 0 712 154 B1**
(45) Veröffentlichungstag und Bekanntmachung des Hinweises auf die Patenterteilung: **17.03.1999**
(21) Anmeldenummer: 95117225.3
(22) Anmeldetag: 02.11.1995
(51) Int. Cl.: H01L 21/70, H01L 21/3205, H01L 21/86

(54) **Verfahren zum Herstellen integrierter Schaltungen mit passiven Bauelementen hoher Güte**
Process for fabricating high-quality integrated circuits containing passive devices
Procédé de fabrication de circuits intégrés de haute qualité contenant des composants passifs

(30) Priorität: 11.11.1994 DE 4440362
(43) Veröffentlichungstag der Anmeldung: 15.05.1996
(73) Patentinhaber: TEMIC Semiconductor GmbH, 74072 Heilbronn (DE)
(72) Erfinder: Kaiser, Reinhold, D-74081 Heilbronn (DE)
(74) Vertreter: Maute, Hans-Jürgen, Dipl.-Ing.

(56) Entgegenhaltungen:
- EP-A- 0 439 634
- US-A- 4 161 742
- US-A- 5 047 828
- PATENT ABSTRACTS OF JAPAN vol. 009, no. 193 (E-334), 9.August 1985 & JP 60 060734 A (MATSUSHITA DENSHI KOGYO KK), 8.April 1985,

## Beschreibung

Die Erfindung betrifft ein Verfahren zum Herstellen von integrierten Schaltungen mit integrierten verlustarmen Kapazitäten, Induktivitäten und Widerstände hoher Güte.

Bei integrierten Schaltungen, die mit hohen Frequenzen z. B. im UHF-Bereich betrieben werden, sind verlustarme passive Bauelemente - Induktivitäten, Kapazitäten und Widerstände (integrierte Polywiderstände) - von besonderer Bedeutung. Werden diese passiven Bauelemente integriert, so leidet darunter hauptsächlich ihre Güte, d. h. die Verluste bei hohen Frequenzen nehmen stark zu. Das ist darauf zurückzuführen, daß zwischen den passiven Bauelementen und dem Substrat weitere leitfähige Zonen angeordnet sind und zumeist das Substrat selbst eine hohe Leitfähigkeit besitzt.

Aufgabe der Erfindung ist daher ein Verfahren zum Herstellen integrierter Schaltungen anzugeben, das die Integration verlustarmer passiver Bauelemente gestattet. Diese Aufgabe wird durch ein Verfahren mit den Merkmalen des Anspruchs 1 gelöst. Die vorteilhafte Weiterbildung des Verfahrens erfolgt gemäß den Merkmalen der abhängigen Ansprüche.

Bei dem beschriebenen Verfahren werden auf einer hochohmigen Halbleiter-Substratscheibe zunächst eine Vielzahl monokristalline, in lateraler und senkrechter Richtung dielektrisch isolierte Boxen zur Aufnahme von aktiven Bauelementen der integrierten Schaltung erzeugt. Geeignete Verfahren sind die Silicon-On-Insulator (SOI)-Technologien. Insbesondere eignen sich die SIMOX-Technologie durch Separation durch implantierten Sauerstoff, die BESOI-Technologie mit durch Wafer-Bonding isolierte Siliziumschichten und die FIPOS-Technologie durch vollständige Isolation durch oxidiertes poröses Silizium. Letztere Technologie ist zum Beispiel in "IEEE Circuits and Devices Magazine", November 1987, Seiten 3 - 7 und Seiten 11 - 15 beschrieben.

Eine Teilmenge der vollständig isolierten Boxen ist zur Aufnahme der aktiven Bauelemente vorgesehen, die durch entsprechende Bipolar-, MOS- oder BiCMOS-Techniken erzeugt werden. Die andere Teilmenge ist zur Aufnahme der passiven Bauelemente vorgesehen. Aus diesen Boxen wird das monokristalline Halbleitermaterial vollständig entfernt. In die leeren Boxen, deren Wände aus einem Dielektrikum bestehen, werden Leitbahnstrukturen durch Abscheiden von leitenden Schichten und deren Strukturierung durch Lithographieprozesse definiert, die schließlich die passiven Bauelemente bilden. Durch die Schichtkombination Leitbahn/Dielektrikum/hochohmiges Substrat sind die in diesen Boxen hergestellten passiven Bauelemente nur mit sehr kleinen Verlusten behaftet, d. h. sie besitzen eine große Güte.

Der Widerstand der Substratscheibe ist vorzugsweise größer als 1 kΩcm und für passive Bauelemente besonders hoher Güte größer als 5 kΩcm.

Die Leitbahnstrukturen der passiven Bauelemente werden von Aluminium, Gold, Kupfer oder Legierungen dieser Metalle sowie Polysilizium oder einem Metallsilizid gebildet. Als Metallsilizide eignen sich insbesondere Titan- oder Tantaldisilizid.

Das Halbleitermaterial der Substratscheibe und monokristallinen Boxen ist vorzugsweise Silizium. Für höchstfrequente Anwendungen kommt auch Silizium-Germanium in Betracht.

In einer anderen Ausgestaltung des Verfahrens werden die Boxen, die zur Aufnahme der passiven Bauelemente vorgesehen sind, mit einem Dielektrikum aufgefüllt, so daß die Oberfläche der Anordnung eingeebnet ist. Dazu eignen sich beispielsweise bekannte Planarisierungstechniken. Die Leitbahnstrukturen der passiven Bauelemente werden anschließend auf der Oberfläche des Dielektrikums über der aufgefüllten, leeren Box erzeugt.

Die auf diese Weise herstellbaren passiven Bauelemente sind Induktivitäten, Kapazitäten und (Poly-) Widerstände. Das zuvor beschriebene Verfahren wird vorzugsweise zum Herstellen von integrierten UHF-Schaltkreisen verwendet.

Kurze Beschreibung der Figur:

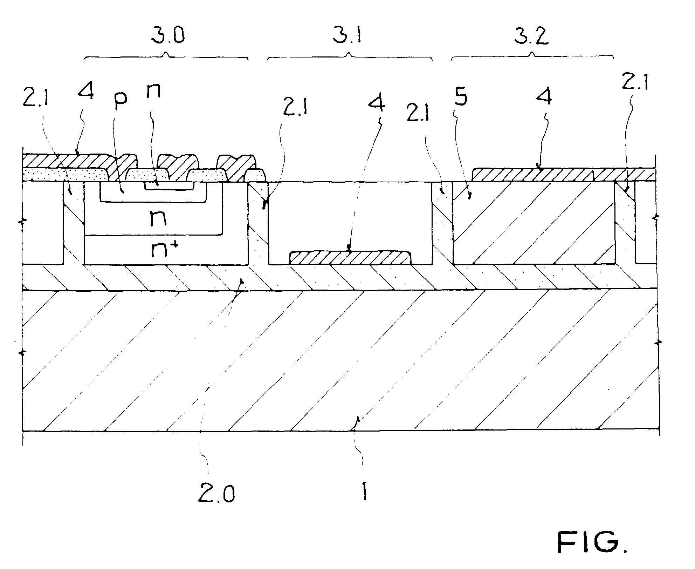

- Figur 1: zeigt einen Querschnitt durch eine integrierte Schaltung mit aktiven und passiven Bauelementen.

Eine hochohmige Silizium-Substratscheibe 1 wird zunächst anhand bekannter Verfahrensschritte soweit prozessiert bis auf ihrer Oberfläche eine Vielzahl von monokristallinen Siliziuminseln 3.0, 3.1, 3.2 entstanden sind, die durch eine dielektrische Schicht 2.0 von der Substratscheibe und durch senkrechte dielektrische Zonen 2.1, die von der Oberfläche bis zur dielektrischen Schicht 2.0 reichen, voneinander isoliert sind. Diese Boxen 3.0, 3.1, 3.2 sind allseitig, mit Ausnahme der Oberfläche von dem Dielektrikum umgeben, also vollständig isoliert.

Im einen Teil der Boxen 3.0 werden die aktiven Bauelemente der integrierten Schaltung ausgebildet. In der Figur 1 ist ein Bipolar-Transistor mit seiner entsprechenden Anschlußmetallisierung dargestellt. Es ist jedoch selbstverständlich, daß auch andere aktive Bauelemente wie z. B. MOS-Transistoren, Dioden etc. ausgebildet werden können.

Im anderen Teil der Boxen 3.1, 3.2 werden die passiven Bauelemente der integrierten Schaltung erzeugt, die besonders verlustarm sein sollen. Dazu wird das Halbleitermaterial aus der Box vollständig entfernt, so daß nur das isolierende Dielektrikum 2.0, 2.1, das den Boden und die Wände der Box bildet, zurückbleibt. Im ersten Fall werden die Leitbahnstrukturen 4 des passiven Bauelements auf der Bodenfläche der Box 3.1 ausgebildet. Im zweiten Fall wird die Box 3.2 zunächst mit einem weiteren Dielektrikum 5 aufgefüllt und anschließend die Leitbahnstrukturen 4 auf der Oberfläche über der aufgefüllten Box ausgebildet. Der zweite Fall weist den Vorteil auf, daß keine Maßnahmen zum Verrunden bzw. Abschrägen der Kanten der Box getroffen werden müssen. In beiden Fällen werden die Leitbahnstrukturen durch einen Photolithographieschritt maskiert und anschließend geätzt, um die entsprechenden Strukturen zu erzeugen. Dies kann in einem gemeinsamen Prozeßschritt mit der ersten Metallisierungsebene der aktiven Bauelemente erfolgen. Es ist jedoch auch möglich, die passiven Bauelemente in einem separaten Prozeß oder zusammen mit einer eventuell vorhandenen weiteren Metallisierungsebene zu erzeugen. Auch sind jede prozeßtechnisch sinnvollen Kombinationen aus mehreren Metallisierungsebenen und separaten Prozessen für die Erzeugung der passiven Bauelemente denkbar.

Als Metallisierung eigenen sich die üblichen, in der Halbleitertechnik gebräuchlichen Materialien, insbesondere Polysilizium - dotiert und undotiert - zum Herstellen von verlustarmen Widerständen; Aluminium, Gold, Kupfer oder Legierungen dieser Metalle und Metallsilizide - hier besonders Titansilizid und Tantalsilizid - zum Herstellen von Kapazitäten und Induktivitäten. Zur Herstellung der Widerstände eignen sich auch die aus der Hybridtechnik bekannten Widerstandsmetalle, wie z. B. CrNi. Sie werden durch bekannte Sputter-Verfahren auf das Dielektrikum aufgebracht und anschließend durch geeignete Verfahren strukturiert.

Das oben beschriebene Verfahren eignet sich besonders zum Herstellen von integrierten UHF-Schaltungen mit verlustarmen Induktivitäten und Kapazitäten.

## Patentansprüche

1. Verfahren zum Herstellen integrierter Schaltungen mit integrierten, verlustarmen passiven Bauelementen mit folgenden, nacheinander ablaufenden Verfahrensschritten:
- Bereitstellen einer hochohmigen Halbleiter-Substratscheibe (1);
- Erzeugen von monokristallinen, in lateraler und senkrechter Richtung dielektrisch isolierter Boxen aus Halbleitermaterial (3.0, 3.1, 3.2) zur Aufnahme von aktiven oder passiven Bauelementen der integrierten Schaltung;
gekennzeichnet durch
- das Entfernen des monokristallinen Materials aus Boxen (3.1, 3.2), die zur Aufnahme passiver Bauelemente vorgesehen sind;
- das Abscheiden und Strukturieren von entsprechenden Leitbahnstrukturen (4) in den leeren Boxen zur Bildung der passiven Bauelemente.

2. Verfahren nach Anspruch 1, dadurch gekennzeichnet, daß der Widerstand der Substratscheibe (1) größer als 1 kΩcm ist.

3. Verfahren nach Anspruch 1 oder 2, dadurch gekennzeichnet, daß der Widerstand der Substratscheibe (1) größer als 5 kΩcm ist.

4. Verfahren nach einem der Ansprüche 1 bis 3, dadurch gekennzeichnet, daß die Leitbahnstrukturen (4) der passiven Bauelemente aus Polysilizium bestehen.

5. Verfahren nach einem der Ansprüche 1 bis 3, dadurch gekennzeichnet, daß die Leitbahnstrukturen (4) der passiven Bauelemente entweder aus Aluminium, Gold, Kupfer oder Legierungen dieser Metalle bestehen.

6. Verfahren nach einem der Ansprüche 1 bis 3, dadurch gekennzeichnet, daß die Leitbahnstrukturen (4) der passiven Bauelemente aus einem Metallsilizid bestehen.

7. Verfahren nach Anspruch 6, dadurch gekennzeichnet, daß das Metallsilizid aus der Gruppe bestehend aus Titansilizid und Tantalsilizid ausgewählt wird.

8. Verfahren nach einem der Ansprüche 1 bis 7, dadurch gekennzeichnet, daß das Halbleitermaterial Silizium oder Silizium-Germanium ist.

9. Verfahren nach einem der vorangegangenen Ansprüche, dadurch gekennzeichnet, daß nach dem Entfernen des monokristallinen Materials aus den Boxen (3.2), die zur Aufnahme der passiven Bauelemente vorgesehen sind, die leere Box durch ein Planarisierungsverfahren mit einem Dielektrikum (5) aufgefüllt wird und daß das Abscheiden von den entsprechenden, die passiven Bauelemente bildenden Leitbahnstrukturen (4) auf die Oberfläche des die leere Box füllenden Dielektrikums erfolgt.

10. Verfahren nach Anspruch 9, dadurch gekennzeichnet, daß die leeren Boxen nur zum Teil mit dem Dielektrikum aufgefüllt werden.

11. Verfahren nach einem der vorangegangenen Ansprüche, dadurch gekennzeichnet, daß die passiven Bauelemente aus der Gruppe gebildet aus Induktivitäten, Kapazitäten und (Poly-) Widerstände entnommen werden.

12. Verfahren nach Anspruch 11, dadurch gekennzeichnet, daß die Leitbahnstrukturen der Widerstände durch Widerstandsmetalle, wie z. B. CrNi, gebildet werden.

13. Verwendung des Verfahrens nach einem der vorangegangenen Ansprüche zum Herstellen von integrierten UHF-Schaltungen.

## Claims

1. Method of manufacturing integrated circuits containing integrated, low-loss passive components, having the following consecutive processing steps:
- provision of a high-resistance semiconductor substrate wafer (1);
- production of monocrystalline boxes (3.0, 3.1, 3.2) made of semiconductor material and dielectrically insulated in lateral and vertical direction for receiving active or passive components of the integrated circuit;
- removal of the monocrystalline material from boxes (3.1, 3.2) provided for receiving passive components;
- deposition and configuration of appropriate conducting patterns (4) in the empty boxes for forming the passive components.

2. Method according to claim 1, characterized in that the resistance of the substrate wafer (1) is greater than 1 kΩcm.

3. Method according to claim 1 or 2, characterized in that the resistance of the substrate wafer (1) is greater than 5 kΩcm.

4. Method according to one of claims 1 to 3, characterized in that the ccnducting patterns (4) of the passive components are made of polysilicon.

5. Method according to one of claims 1 to 3, characterized in that the conducting patterns (4) of the passive components are made of either aluminium, gold, copper or alloys of said metals.

6. Method according to one of claims 1 to 3, characterized in that the conducting patterns (4) of the passive components are made of a metal silicide.

7. Method according to claim 6, characterized in that the metal silicide is selected from the group comprising titanium silicide and tantalum silicide.

8. Method according to one of claims 1 to 7, characterized in that the semiconductor material is silicon or silicon germanium.

9. Method according to one of the preceding claims, characterized in that, after removal of the monocrystalline material from the boxes (3.2) provided for receiving the passive components, the empty box is filled with a dielectric (5) using a planar technique and that the deposition of the appropriate conducting patterns (4) forming the passive components is effected onto the surface of the dielectric filling the empty box.

10. Method according to claim 9, characterized in that the empty boxes are only partially filled with the dielectric.

11. Method according to one of the preceding claims, characterized in that the passive components are taken from the group formed by inductors, capacitors and (poly)resistors.

12. Method according to claim 11, characterized in that the conducting patterns of the resistors are formed by resistor metals such as, for example, CrNi.

13. Use of the method according to one of the preceding claims for manufacturing UHF integrated circuits.

## Revendications

1. Procédé de fabrication de circuits intégrés comprenant des composants passifs à faibles pertes, intégrés, comportant les étapes de procédé successives suivantes :
- préparation d'un disque de substrat semiconducteur fortement ohmique (1) ;
- réalisation de cavités en matériau semiconducteur, monocristallines, isolées diélectriquement dans les directions latérale et verticale (3.0, 3.1, 3.2) en vue de la réception de composants actifs ou passifs du circuit intégré ;
- élimination du matériau monocristallin des cavités (3.1, 3.2), qui sont prévues pour la réception de composants passifs ;
- séparation et structuration de configurations de piste conductrice correspondantes (4) dans les cavités vides en vue de la formation des composants passifs.

2. Procédé selon la revendication 1, caractérisé en ce que la résistance du disque de substrat (1) est supérieure à 1 kΩcm.

3. Procédé selon la revendication 1 ou 2, caractérisé en ce que la résistance du disque de substrat (1) est supérieure à 5 kΩcm.

4. Procédé selon l'une quelconque des revendications 1 à 3, caractérisé en ce que les configurations de piste conductrice (4) des composants passifs sont en silicium polycristallin.

5. Procédé selon l'une quelconque des revendications 1 à 3, caractérisé en ce que les configurations de piste conductrice (4) des composants passifs sont, soit en aluminium, or, cuivre, soit en alliages de ces métaux.

6. Procédé selon l'une quelconque des revendications 1 à 3, caractérisé en ce que les configurations de piste conductrice (4) des composants passifs sont en un siliciure métallique.

7. Procédé selon la revendication 6, caractérisé en ce que le siliciure métallique est choisi parmi le groupe se composant du siliciure de titane et du siliciure de tantale.

8. Procédé selon l'une quelconque des revendications 1 à 7, caractérisé en ce que le matériau semiconducteur est du silicium ou du silicium-germanium.

9. Procédé selon l'une quelconque des revendications précédentes, caractérisé en ce qu'après l'élimination du matériau monocristallin des cavités (3.2), qui sont prévues pour la réception des composants passifs, la cavité vide est remplie par un procédé d'aplanissement avec un diélectrique (5) et en ce que la séparation des configurations de piste conductrice (4) correspondantes formant les composants passifs s'effectue sur la surface du diélectrique remplissant la cavité vide.

10. Procédé selon la revendication 9, caractérisé en ce que les cavités vides sont remplies seulement partiellement de diélectrique.

11. Procédé selon l'une quelconque des revendications précédentes, caractérisé en ce que les composants passifs appartiennent au groupe formé par les inductances, les condensateurs et les (poly-)résistances.

12. Procédé selon la revendication 11, caractérisé en ce que les configurations de piste conductrice des résistances sont formées par des métaux résistants, comme par exemple CrNi.

13. Utilisation du procédé selon l'une quelconque des revendications précédentes en vue de la fabrication de circuits intégrés UHF.
